# EUROPEAN PATENT SPECIFICATION

(11) **EP 2 439 150 B1**
(45) Date of publication and mention of the grant of the patent: **23.12.2020**
(21) Application number: 10783172.9
(22) Date of filing: 04.06.2010
(51) Int. Cl.: B65D 81/24, B65D 81/26, B65D 85/48, H01L 31/042, H01L 21/673

(54) **PACKAGE BODY FOR STORING OR TRANSPORTING SOLAR CELL SEALING FILM AND METHOD FOR STORING OR TRANSPORTING SOLAR CELL SEALING FILM**
VERPACKUNGSELEMENT ZUR LAGERUNG ODER ZUM TRANSPORT EINES SOLARZELLENDICHTUNGSFILMS SOWIE VERFAHREN ZUR LAGERUNG ODER ZUM TRANSPORT EINES SOLARZELLENDICHTUNGSFILM
CORPS D'EMBALLAGE POUR STOCKER OU TRANSPORTER UN FILM D'ÉTANCHÉITÉ DE CELLULE SOLAIRE ET PROCÉDÉ POUR STOCKER OU TRANSPORTER UN FILM D'ÉTANCHÉITÉ DE CELLULE SOLAIRE

(30) Priority: 05.06.2009 JP 2009136608
(43) Date of publication of application: 11.04.2012
(73) Proprietor: Mitsui Chemicals Tohcello, Inc., Tokyo 101-8485 (JP)
(72) Inventor: MORI, Hiroshi, Chiba 299-0265 (JP); MUROFUSHI, Takanobu, Chiba 299-0265 (JP); IKENAGA, Shigenobu, Chiba 299-0265 (JP); HAKUTA, Takashi, Chiba 299-0265 (JP); ZENKOH, Hirofumi, Chiyoda-ku Tokyo 102-0073 (JP)
(74) Representative: Hoffmann Eitle
(86) International application number: PCT/JP2010/003749
(87) International publication number: WO 2010/140384

(56) References cited:
- WO-A2-2005/090427
- JP-A- 5 235 393
- JP-A- 9 328 520
- JP-A- 2004 214 641
- JP-A- 2006 229 060
- JP-A- 2006 229 060
- JP-A- 2007 103 738
- US-A1- 2006 201 544
- US-A1- 2008 115 825

## Description

### Technical Field

The present invention relates to a method and package for storing or transporting a solar cell encapsulating film.

### Background Art

Recently, with growing consciousness about environmental issues, solar cells have attracted attention as a clean energy source.

A solar cell module is generally manufactured by stacking module components such as a transparent front plate, a solar cell encapsulating film, solar cells (each manufactured by depositing an electrode on monocrystalline or polycrystalline silicon), another solar cell encapsulating film and a back protective sheet, and laminating the stacked module components under vacuum condition for fixing the encapsulating films.

Aiming to cut the use of silicon material, the development of thin-film solar cell modules is under way. This form of solar cell module is designed to reduce the amount of silicon in solar cells by depositing thin films of silicon onto the transparent front plate or the like.

Solar cell modules are required to operate stably for a long period in such an environment where the surrounding condition changes, e.g., outdoor. Thus, solar cell encapsulating films require flexibility that prevents possible solar cell breakage due to physical impact, as well as sealing property and adhesion that prevent possible corrosion of solar cell electrodes by seep water. In particular, solar cell encapsulating films are required to fill and seal the space between the transparent front plate and solar cells and between the solar cells and back protective sheet.

Aiming to meet these requirements, silane compounds with reactive groups that exert good adhesion to inorganic material such as glass (e.g., alkoxysilyl groups) have been used as adhesion promoters. Among such silane compounds, silane-modified resins prepared by copolymerization of ethylenically-unsaturated silane compounds with other polymerizable resins have been used as adhesion promoters (see, e.g., Patent Literature 1). In cases where solar cell encapsulating films are to be fixed by crosslinking (curing) by means of heat lamination, it has been proposed in the art to add to the soalr cell encapsulating films crosslinking agents (e.g., organic peroxides) and/or additives for imparting adhesion to solar cells or other module components or durability (see, e.g., Patent Literature 2).

Accordingly, solar cell encapsulating films are generally stored until use or transported in solar cell module manufacturing factories while containing unreacted crosslinking agents and additives such as adhesives.

Under the foregoing circumstance, solar cell encapsulating films suffer from a risk of possible reduction in adhesion strength due to degradation of the unreacted adhesion promoters during storage or transportation.

JP 2006-229060 A relates to a method for manufacturing a solar cell panel comprising the steps of manufacturing a semi-fabricated product of a solar cell panel, packing the semi-fabricated product into a solar cell panel semi-fabricated product package, and processing the semi-product unpacked from the package . The package comprises the semi-fabricated product and sheets for sealing the semi-fabricated product. The sheets are made of a material preferably having no light transmission property and having a steam transmission rate smaller than 0.5 g/m²/24h.

US 2008/115825 A1 relates to an electronic device module comprising: A. At least one electronic device, e.g., a solar cell, and B. A polymeric material in intimate contact with at least one surface of the electronic device, the polymeric material comprising an ethylene multi-block copolymer. Typically, the polyolefin material is an ethylene multi-block copolymer with a density of less than about 0.90 grams per cubic centimeter (g/cc). The polymeric material can fully encapsulate the electronic device, or it can be laminated to one face surface of the device. Optionally, the polymeric material can further comprise a scorch inhibitor, and the copolymer can remain uncrosslinked or it can be crosslinked.

US 2006/201544 A1 relates to a filler sheet for a solar cell module made of a resin film produced by a resin composition comprising a copolymer of an alpha-olefin and an ethylenic unsaturated silane compound, or a modified or condensed body thereof, and one or more selected from the group consisting of a light resisting agent, an ultraviolet absorbent and a thermal stabilizer.

### Citation List

### Patent Literature

[PTL 1] Japanese Patent Application Laid-Open No.2004-214641
[PTL 2] Japanese Patent Application Laid-Open No.2007-281135

### Summary of Invention

### Technical Problem

It is an object of the present invention to provide a method and package for storing or transporting a solar cell encapsulating film, wherein the method and package can store or transport a solar cell encapsulating film while retaining its adhesion to a substrate, solar cells, etc., at a practicable level or higher.

### Solution to Problem

The present invention relates to a method and package for storing or transporting a solar cell encapsulating film.

Specifically, the present invention relates to methods and package bodies for storing or transporting a solar cell encapsulating film given below.
[1] A package for storing or transporting a solar cell encapsulating film, including:
   a solar cell encapsulating film containing a silane compound and/or a silane-modified resin; and
   a package bag packaging the solar cell encapsulating film,
   wherein an absolute humidity inside the package is 3 to 8 g/m³.
[2] The package according to [1] above, wherein a base component of the solar cell encapsulating film is an ethylene/a-olefin copolymer.
[3] The package according to [1] above, wherein the ethylene/a-olefin copolymer satisfies the following requirements a) to e):
   a) Density = 900 to 940 kg/m³;
   b) Peak melt temperature as measured by differential scanning calorimetry (DSC) = 90°C to 125°C;
   c) Melt flow rate (MFR2) as measured in accordance with JIS K-6721 at 190°C under a load of 2.16 kg = 0.1 to 100 g/10min;
   d) Mw/Mn ratio = 1.2 to 3.5; and
   e) Metal residue content = 50 weightppm or less.
[4] The package according to [1] above, wherein the silane compound and/or the silane-modified resin have an alkoxysilyl group.
[5] The package according to [2] above, wherein an amount of the silane compound contained in the solar cell encapsulating film is 0.1 to 3.0 weight parts per 100 weight parts of the ethylene/a-olefin copolymer.
[6] The package according to [2] above, wherein the silane-modified resin is a modified product obtainable by grafting 100 weight parts of the ethylene/a-olefin copolymer with 0.1 to 5 weight parts of a polymerizable silane compound.
[7] The package according to [1] above, wherein a silicon (Si) atom content in the solar cell encapsulating film is 300 to 4,000 ppm based on a weight of the solar cell encapsulating film.
[8] The package according to [1] above, wherein package comprises a stack of the plurality of solar cell encapsulating films.
[9] The package according to [1] above, wherein the package bag contains a polyolefin resin.
[10] The package according to [1] above, wherein the package bag has a moisture permeability of 1 g/(24hr·m²) or less.
[11] The package according to [1], further including a humidity conditioner inside the package.
[12] The package according to [11] above, wherein the humidity conditioner is at least one member selected from the group consisting of silica gel, calcium chloride and magnesium chloride.
[13] A method of storing or transporting a solar cell encapsulating film containing a silane compound and/or a silane-modified resin, the method including:
   packaging the solar cell encapsulating film with a package bag to provide a package having an internal absolute humidity of 3 to 8 g/m³; and
   storing or transporting the solar cell encapsulating film in a dark environment for 50 hours or longer.
[14] A solar cell module including:
   a transparent front protective member;
   an encapsulating layer formed of a solar cell encapsulating film or of a cured product thereof, the solar cell encapsulating film taken out from the package according to [1] above;
   a solar cell encapsulated with the encapsulating layer; and
   a back protective member,
   wherein the encapsulating layer is held between the transparent front protective member and the back protective member, each arranged on the opposite surfaces, constitutes an example useful for understanding the invention.
[15] A method of manufacturing a solar cell module, useful for understanding the invention, including:
   a first step of stacking, a transparent front protective member, a first solar cell encapsulating film taken out from the package according to [1] above, a solar cell, a second solar cell encapsulating film taken out from the package according to [1] above, and a back protective member, in this order, to form a stack; and
   a second step of laminating the stack obtained in the first step so as to integrate .
[16] A method of manufacturing a solar cell module, useful for understanding the invention, including:
   a first step of stacking, a transparent front protective member, a solar cell, a solar cell encapsulating film taken out from the package according to [1] above, and a back protective member, in this order, or
   stacking, the transparent front protective member, the solar cell encapsulating film taken out from the package according to [1] above, the solar cell, and the back protective member, in this order, to form a stack; and
   a second step of laminating the stack obtained in the first step so as to integrate.

### Advantageous Effects of Invention

According to the present invention, it is possible to allow a solar cell encapsulating film to fully exert its adhesion upon manufacturing of a solar cell module, while avoiding adhesion reduction during storage or transportation. This allows for prevention of breakage of solar cells by external impact during the operation of solar cell module or electrode corrosion by water from the atmosphere.

### Brief Description of Drawings

Figs.1A to 1C are schematic views illustrating an example of a method of manufacturing a package according to an embodiment of the present invention;
Fig.2 is a cross-sectional view illustrating an example of a configuration of a solar cell module;
Fig.3A is a plan view illustrating an example of a configuration of a light-incident surface of a solar cell; and
Fig.3B is a plan view illustrating an example of a configuration of a back surface of a solar cell.

### Description of Embodiments

A package of the present invention is a package used for storing or transporting a solar cell encapsulating film, the package including i) a solar cell encapsulating film containing a silane compound and/or a silane-modified resin and ii) a package bag packaging the solar cell encapsulating film, wherein the absolute humidity inside the package is 3 to 8g/m³. The present invention also relates to a method of storing or transporting a solar cell encapsulating film by means of the package, and a solar cell module manufactured using the solar cell encapsulating film. Hereinafter, the above requirements specified in the present invention will be described in more detail in relation to a solar cell encapsulating film, a package for a solar cell encapsulating film, and a method of manufacturing a solar cell module.

Note in the following description that ranges are inclusive of end points; for example, the expression "10 to 100" is equivalent to 10 or more to 100 or less.

### 1. Solar Cell Encapsulating Film

A solar cell encapsulating film contains i) a base resin, a major component, ii) an adhesion promoter, and iii) optional additive(s) added as needed. The adhesion promoter may be a silane-modified resin modified with a silane modifier. When a silane-modified resin is employed as the adhesion promoter, the silane-modified resin itself can serve as the base resin.

Examples of the base resin include ethylene homopolymers and copolymers of ethylene and at least one comonomer other than ethylene (hereinafter also referred to as "ethylene copolymers" or "ethylene polymers"). The ethylene copolymers may be either random copolymers or block copolymers of ethylene and one or more other comonomers, but preferably are random copolymers. Examples of comonomers for the ethylene copolymers include C₃₋₂₀ α-olefins, cyclic olefins and vinyl acetate.

Examples of the C₃₋₂₀ α-olefins include propylene, 1-butene, 1-pentene, 1-hexene, 4-methyl-1-pentene, 1-octene, 1-decene, 1-dodecene, 1-tetradecene, 1-hexadecene, 1-octadecene, and 1-eicosene.

Examples of the cyclic olefins include norbornene derivatives, tricyclo-3-decene derivatives, tricyclo-3-undecene derivatives, tetracyclo-3-dodecene derivatives, pentacyclo-4-pentadecene derivatives, pentacyclo-pentadecadiene derivatives, pentacyclo-3-pentadecene derivatives, pentacyclo-4-hexadecene derivatives, pentacyclo-3-hexadecene derivatives, hexacyclo-4-heptadecene derivatives, heptacyclo-5-eicosene derivatives, heptacyclo-4-eicosene derivatives, heptacyclo-5-heneicosen derivatives, octacyclo-5-docosene derivatives, nonacyclo-5-pentacosene derivatives, nonacyclo-6-hexacosene derivatives, cyclopentadiene-acenaphthylene adduct, 1,4-methano-1,4,4a,9a-tetrahydrofluorene derivatives, 1,4-methano-1,4,4a,5,10,10a-hexahydroanthracene derivative, and C₃₋₂₀ cycloalkylene derivatives. Among them, tetracyclo[4.4.0.12,5.17,10]-3-dodecene derivatives, and hexacyclo[6.6.1.13,6.110,13.02,7.09,14]-4-heptadecene derivative are preferable, with tetracyclo[4.4.0.12,5.17,10]-3-dodecene derivatives being particularly preferable.

The comonomers (a-olefins, cyclic olefins and vinyl acetate) for the ethylene copolymers may be used alone or in combination.

The copolymer of vinyl acetate and ethylene (ethylene/vinyl acetate copolymer) is suitably used in view of its high transparency, flexibility and durability as well as excellent compatibility with additives. However, when cthylene/vinyl acetate copolymer (EVA) is used, there is a need to add peroxide to impart sufficient heat resistance and to cure the resin by crosslinking through heating in the manufacturing process of a solar cell module. The crosslinking treatment is time-consuming and therefore may reduce the productivity of solar cell modules. Moreover, there is concern that the vinyl acetate component on heating decomposes to give acetic acid gas or the like which causes deterioration of electrodes and other components of the solar cells.

On the other hand, since ethylene/a-olefin copolymers and ethylene/cyclic olefin copolymers have high heat resistance, there is no need to add peroxides to a solar cell encapsulating film, nor to heat the resin for curing during the manufacture of a solar cell module. Thus, these ethylene/olefin copolymers are superior to EVA in terms of productivity of solar cell modules and the likelihood of deterioration of the solar cells by cracked gas. However, since the ethylene/a-olefin copolymers and ethylene/cyclic olefin copolymers have no polar groups or small numbers of polar groups if present, they show low affinity for the surface of the transparent front plate or the like, which is composed of inorganic material such as glass; therefore, in many cases, they have low adhesion strength compared to EVA.

For this reason, when the ethylene/a-olefin copolymers and ethylene/cyclic olefin copolymers are to be used as base resin of a solar cell encapsulating film, it is preferable to add an adhesion promoter later described. It is particularly preferable to add silane-modified resin or to modify the base resin with silane to form silane-modified resin.

For the base resin for a solar cell encapsulating film, it is preferable to employ ethylene/α-olefin copolymers that satisfy all of the following requirements:
a) Density = 900 to 940 kg/m³;
b) Peak melt temperature as measured by differential scanning calorimetry (DSC) = 90°C to 125°C;
c) Melt flow rate (MFR2) as measured in accordance with JIS K-6721 at 190°C under a load of 2.16 kg = 0.1 to 100 g/10min;
d) Mw/Mn ratio = 1.2 to 3.5; and
e) Metal residue content = 50 ppm or less.
Each requirement will be described below.

### (Requirement a))

The density of the ethylene/a-olefin copolymer is 900 to 940 kg/m³, preferably 900 to 935 kg/m³, more preferably 900 to 930 kg/m³, still more preferably 900 to 925 kg/m³, yet more preferably 905 to 925 kg/m³, most preferably 905 to 923 kg/m³. When the density of the ethylene/a-olefin copolymer is less than 900 kg/m³, the resultant solar cell encapsulating film tends to have low heat resistance. For this reason, when a solar cell module is held inclined during photovoltaic power generation, there is tendency that glass, electrodes and other components gradually slip and finally fall down. On the other hand, when the density of the ethylene/a-olefin copolymer is greater than 940 kg/m³, the solar cell encapsulating film may become less flexible so that cracking of crystalline solar cells or separation of silver electrodes may occur during the lamination process of a solar cell module. Moreover, it may become necessary to increase the temperature during the lamination process.

The density of the ethylene/a-olefin copolymer depends on the comonomer content such as α-olefin content. The density of the resultant ethylene/a-olefin copolymer increases with decreasing comonomer content, and vice versa. The comonomer content in the ethylene/a-olefin copolymer is known to be determined by the comonomer/ethylene ratio in the polymerization system (see, e.g., Walter Kaminsky, Makromol, Chem. 193, p.606 (1992)). Thus, the density of the ethylene/a-olefin copolymer can be adjusted by adjusting the comonomer/ethylene ratio.

### (Requirement b))

The peak melt temperature of the ethylene/a-olefin copolymer as measured by DSC is 90°C to 125°C, preferably 90°C to 120°C, more preferably 90°C to 115°C. When the peak melt temperature of the ethylene/a-olefin copolymer is less than 90°C, there is tendency that the resultant solar cell encapsulating film has low heat resistance. For this reason, when a solar cell module is held inclined during photovoltaic power generation, glass, electrodes and other components may gradually slip and fall down. On the other hand, when the peak melt temperature of the ethylene/a-olefin copolymer is greater than 125°C, the solar cell encapsulating film may become less flexible so that cracking of crystalline solar cells or separation of silver electrodes may occur during the lamination process of a solar cell module. Moreover, it may become necessary to increase the temperature during the lamination process.

Similarly to density, the peak melt temperature of the ethylene/a-olefin copolymer depends on the comonomer content, such as α-olefin content. The peak melt temperature of the resultant ethylene/α-olefin copolymer increases with decreasing comonomer content, and vice versa. The comonomer content in the ethylene/a-olefin copolymer is known to be determined by the comonomer/ethylene ratio in the polymerization system (see, e.g., Walter Kaminsky, Makromol. Chem. 193, p.606 (1992)). Thus, the peak melt temperature of the ethylene/a-olefin copolymer can be adjusted by adjusting the comonomer/ethylene ratio.

### (Requirement c))

The melt flow rate (MFR2) of the ethylene/a-olefin copolymer is 0.1 to 100 g/10min, preferably 0.5 to 50 g/10min, more preferably 0.5 to 20 g/10min, as measured in accordance with JIS K-6721 at 190°C under a load of 2.16 kg. When MFR2 of the ethylene/a-olefin copolymer is less than 0.1 g/10min, an ethylene resin composition containing the ethylene/a-olefin copolymer has less flowability, which reduces the sheet extrusion molding productivity. On the other hand, when MFR2 is greater than 100 g/10min, the ethylene resin composition becomes so flowable that sheet molding becomes difficult, and moreover, the resultant solar cell encapsulating film has poor mechanical properties, such as poor tensile strength.

MFR2 depends on the molecular weight of the ethylene/a-olefin copolymer. Specifically, there is tendency that the melt flow rate decreases with increasing molecular weight of the ethylene/a-olefin copolymer and vice versa. The molecular weight of ethylene copolymers such as ethylene/a-olefin copolymers is known to vary depending on the hydrogen/ethylene ratio in the polymer system (see, e.g., Kazuo Soga, KODANSHA "CATALYTIC OLEFIN POLYMERIZATION" p.376 (1990)). Thus, by appropriately adjusting the hydrogen (H₂)/ethylene ratio in the polymer system, it is possible to produce an ethylene/a-olefin copolymer with desired MFR2.

### (Requirement d))

The ratio of weight-average molecular weight (Mw) to number-average molecular weight (Mn) of the ethylene/a-olefin copolymer, (Mw/Mn), as measured by gel permeation chromatography (GPC) is 1.2 to 3.5, preferably 1.2 to 3.2, more preferably 1.2 to 2.8. When the Mw/Mn ratio of the ethylene/a-olefin copolymer is less than 1.2, a living polymer yields, which is industrially disadvantageous because the amount of catalyst per unit amount of ethylene/a-olefin copolymer to be produced increases,and therefore production costs increases. On the other hand, when the Mw/Mn ratio of the ethylene/a-olefin copolymer is greater than 3.5, the solar cell encapsulating film tends to have low impact strength. Moreover, the ethylene/a-olefin copolymer becomes so sticky that sheet blocking occurs, which makes separation of the solar cell encapsulating film (sheet) difficult.

The Mw/Mn ratio of the ethylene/a-olefin copolymer is generally influenced by the composition distribution. For example, in the case of batch slurry polymerization, the Mw/Mn ratio tends to be small at a low comonomer conversion, and tends to be large at a high comonomer conversion. Moreover, by shortening the polymerization time, the comonomer conversion becomes small, whereby degradation of the active species of polymerization catalyst can be suppressed, and accordingly, the composition distribution becomes narrow so that the Mw/Mn tends to be small. On the other hand, by prolonging the polymerization time, the comonomer conversion becomes high so that degradation of the polymerization catalyst occurs. Accordingly, the composition distribution becomes broad, and therefore the Mw/Mn ratio tends to become large.

In the case of continuous gas phase polymerization or solution polymerization, by shortening the mean residence time, degradation of the polymerization catalyst is suppressed and therefore the composition distribution becomes narrow, whereby the Mw/Mn ratio tends to be small. On the other hand, when the mean residence time is prolonged, deterioration of the active species of polymerization catalyst occurs and therefore the composition distribution becomes broad, whereby the Mw/Mn ratio tends to become large.

### (Requirement e))

The metal residue content in the ethylene/a-olefin copolymer is 50 weightppm or less, preferably 0.1 to 45 weightppm, more preferably 0.1 to 40 weightppm. When the metal residue content in the ethylene/a-olefin copolymer is less than 0.1 weightppm, decalcification of polymerization catalyst may be indispensable, which increases plant's fixed costs as well as serve costs leading to increased production costs. Moreover, since a large quantity of acid or base is required for decalcification, it becomes likely that the acid or base remains in the ethylene/a-olefin copolymer). The remaining acid or base may corrode electrodes and other members. On the other hand, when the metal residue content in the ethylene/a-olefin copolymer is greater than 50 weightppm, metal residues reduce the volume resistivity and dielectric breakdown strength.

The metal residue content in the ethylene/a-olefin copolymer depends on the polymerization activity of a polymerization catalyst such as a metallocene compound. When a polymerization catalyst with a high polymerization activity is used, the amount of the polymerization catalyst with respect to monomer can be reduced, and therefore, the metal residue content in the ethylene/a-olefin copolymer can be reduced. Thus, the use of a polymerization catalyst with a high polymerization activity may be one of suitable approaches to prepare an ethylene/a-olefin copolymer with a low metal residue content. Other suitable approaches to reduce residual metal content by increasing the polymerization activity include conducting polymerization at a polymerization temperature optimal for a polymerization catalyst used, and increasing the polymerization pressure as much as possible, and increasing the monomer concentration per unit polymerization catalyst.

When an organic aluminumoxy compound, a compound that forms ion pairs by reaction with a metallocene compound, or an organic aluminum compound or the like is used as a polymerization catalyst, reducing the added amount of these compounds as much as possible is also a suitable approach to reduce the metal residue content. In addition, increasing the polymerization activity in different ways may also be a suitable approach to reduce the metal residue content. The metal residue content can be reduced by employing an acid, alkali, or a chelating agent such as methyl acetoacetate for decalcification. However, this approach is not suitable in the present invention because when they remain in the ethylene/a-olefin copolymer, they may facilitate corrosion of the thin-film electrodes.

The ethylene/a-olefin copolymer can be produced by a polymerization reaction in which a conventional catalyst component known in the art that can prepare an ethylene polymer is used. Examples of the catalyst component include Ziegler-Natta catalysts and metallocene compounds. Among them, metallocene compounds, which have a high polymerization activity per unit transition metal, are preferable because an ethylene/a-olefin copolymer with less metal residues can be obtained without decalcification. Metallocene compounds described in JP-A Nos.2006-077261, 2008-231265 and 2005-314680 can be used, for example. Metallocene compounds which have different structure from those of the metallocene compounds dislcosed in these Patent Literature can also be used. Two or more different metallocene compounds may be blended.

An ethylene/a-olefin copolymer can be produced by supplying monomers in a polymerization system under the presence of an olefin polymerization catalyst consisting of (I) a metallocene compound known in the art and of (II) at least one compound (referred to as a "promoter" in some cases) selected from the group consisting of (II-1) an organic aluminumoxy compound, (II-2) a compound that forms ion pairs by reaction with the metallocene compound, and (II-3) an organic aluminum compound .

For (II-1) organic aluminumoxy compound, (II-2) compound that forms ion pairs by reaction with the metallocene compound and (II-3) organic aluminum compound, those described in JP-A Nos.2006-077261, 2008-231265 and 2005-314680 can be used, for example. Metallocene compounds which have different structure from those of the metallocene compounds disclosed in these Patent Literature can also be used. These compounds may be individually charged into the polymerization system or may be previously contacted with one another before being charged into the polymerization system. The metallocene compound may be loaded on an inorganic oxide microparticle carrier such as that described in JP-A No.2005-314680.

Polymerization may be a gas-phase polymerization process known in the art or a liquid-phase polymerization process such as slurry polymerization or solution polymerization. Polymerization is preferably gas-phase polymerization or slurry polymerization, a polymerization process where polymerization activity is high and less metal residue is produced. Slurry polymerization and solution polymerization are effected under the presence of an non-reactive carbohydrate medium, such as an aliphatic hydrocarbon such as propane, butane, pentane, hexane, heptane, octane, decane, dodecane, and kerosene; an alicyclic hydrocarbon such as cyclopentane, cyclohexane, and methylcyclopentane; an aromatic hydrocarbon such as benzene, toluene, and xylene; a halogenated hydrocarbon such as ethylenechloride, chlorobenzene, and dichloromethane; or a mixture thereof. Among these non-reactive hydrocarbon solvents, aliphatic hydrocarbons and alicycilc hydrocarbons are preferable. The ethylene/a-olefin copolymer prepared through the above polymerization process may be subjected to conventional decalcification treatment to remove the catalyst component and inorganic oxide microparticle carrier.

When ethylene/a-olefin copolymers or ethylene/cyclic olefin copolymers are employed as base resin of solar cell encapsulating films, it is preferable to added adhesion promoters (e.g., silane compounds) later described. In addition to adding the adhesion promoters it is preferable to add radically polymerizable unsaturated compounds as auxiliary adhesion promoters, which are grafted to the copolymer chain by known techniques such as graft polymeriztion to improve adhesion between the transparent front substrate or the like and the copolymer. Preferable radically polymerizable unsaturated compounds are those having a polar group such as a functional group that can be bound to hydrogen.

Examples of the radically polymerizable unsaturated compounds, which are auxiliary adhesion promoters, include hydroxyl group-containing ethylenically-unsaturated compounds, amino group-containing ethylenically-unsaturated compounds, epoxy group-containing ethylenically-unsaturated compounds, aromatic vinyl compounds, unsaturated carboxylic acids or derivatives thereof, vinylester compounds, vinylchloride, and carbodiimide compounds, with unsaturated carboxylic acids or derivatives thereof being preferable. Specific examples thereof include unsaturated carboxylic acids such as acrylic acid, methacrylic acid, maleic acid, fumaric acid tetrahydrophthalic acid, itaconic acid, citraconic acid, crotonic acid, isocrotonic acid, and Nadic acid^{(™)} (endo-cis -bicyclo[2.2.1]hept-5-ene-2,3-dicarboxylic acid), and derivatives thereof. Examples of "derivatives" include acid halides, amides, imides, anhydrides and esters.

Specific examples of the derivatives include maleyl chloride, maleimide, maleic anhydride, anhydrous citraconic acid, 2-methylmaleic anhydride, 2-chloromaleic anhydride, 2,3-dimethylmaleic anhydride, 4-methyl-4-cyclohexene-1,2-dicarboxylic anhydride, monomethyl maleate, dimethyl maleate, glycidyl malate, methyl acrylate, ethyl acrylate, butyl acrylate, methyl methacrylate, ethyl methacrylate, and butyl methacrylate.

These unsaturated carboxylic acids and derivatives thereof may be used alone or in combination. Among them, unsaturated dicarboxylic acids and derivatives thereof are preferable, with maleic acid, Nadic acid or acid anhydride thereof being particularly preferable.

The compounding amount of the auxiliary adhesion promoter is generally 0.1 to 5 weight parts, preferably 0.1 to 4 weight parts, per 100 weight parts of the ethylene/a-olefin copolymer or ethylene/cyclic olefin copolymer. When the auxiliary adhesion promoter content is within the range, transparency, flexibility, etc. of the solar cell encapsulating film are not adversely affected while fully improving its adhesion.

A solar cell encapsulating film used in the present invention contains an adhesion promoter for improving adhesion to solar cells and protective members.

The adhesion promoter may be either a silane compound to be added to the base resin or silane-modified resin obtained by graft-modifying the base resin with a polymerizable silane compound such as an ethylenically-unsaturated silane compound. The silane compound and silane-modified resin may be used in combination.

Suitable silane compounds and silane-modified resins are those having reactive groups such as alkoxy groups or halogens, which can be bound to silicon. This is because in a solar cell module (later described) these reactive groups react with functional groups on the surface of module members which the solar cell encapsulating film contact, forming chemical bonds or physical bonds (e.g., hydrogen bonds) between them to significantly improve adhesion between the encapsulating film and the members. The members which the solar cell encapsulating film contact include solar cells formed of silicon or the like, and a front protective member made of inorganic material such as glass. Adhesion increases with increasing activity of the reactive groups which the silane compounds or silane-modified resins have, as well as with increasing number of the reactive groups. However, when the activity of the reactive groups is too high, it may result in failure to impart adhesion during the manufacture of a solar cell module because the adhesion promoter undergoes reactions during storage or transportation of the solar cell encapsulating film.

The silane compounds used as adhesion promoters are preferably silane coupling agents. Specific examples of the silane coupling agents include γ-chloropropyltrimetoxysilane, vinyl trichlorosilane, vinyltriethoxysilane, vinyl-tris-(β-methoxyethoxy)silane, γ-methacryloxypropyltrimethoxysilane, β-(3,4-ethoxycyclehexyl)ethyltrimethoxysilane, γ-glycidoxypropyltrimetoxysilane, vinyltriacetoxysilane, γ-mercaptopropyltrimethoxysilane, γ-aminopropyltrimethoxysilane, and N-β-(aminoethyl)-γ-aminopropyltrimethoxysilane. Among them, alkoxysilanes are suitable in view of the stability of the adhesion promoter because they are present in relatively stable form at room temperature and in the neutral pH region. Nevertheless, alkoxysilanes have the drawback that their stability prevents the solar cell encapsulating film from fully exerting adhesion during the manufacture of a solar cell module.

The compounding amount of the silane compound is 0.1 to 3.0 weight parts, preferably 0.2 to 1.5 weight parts, per 100 weight parts of the base resin.

The silane-modified resins can be produced by known processes. There are no particular limitations on the process of producing the silane-modified resins; for example, the silane-modified resins are preferably produced by graft-modification of base resins with polymerizable silane compounds under the presence of organic peroxide. This is because in a polymer in which the base resin (main chain) is grafted with the polymerizable silane compound (side chains), the steric hindrance of reactive groups (e.g., alkoxyl groups) of the polymerizable silane compound, which contribute to imparting adhesion, is small, whereby the adhesion of the encapsulating film to the surface of module components such as a front protective member improves more efficiently.

There are no particular limitations on the above polymerizable silane compounds; conventional polymerizable silane compounds known in the art can be employed. It is possible to employ ethylenically-unsaturated silane compounds as the polymerizable silane compounds. Specific examples of the ethylenically-unsaturated silane compounds include vinyltriethoxysilane, vinyltrimetoxysilane, vinyltris(β-methoxyethoxysilane), γ-glycidoxypropyltrimetoxysilane, γ-aminopropyltriethoxysilane, and γ-methacryloxypropyltrimethoxy silane.

The amount of the polymerizable silane compound grafted is generally 0.1 to 5 weight parts, preferably 0.1 to 4 weight parts, per 100 weight parts of the base resin. When the amount of the polymerizable silane compound grafted is within the range, transparency, flexibility, etc. of the resultant ethylene copolymer are not adversely affected while fully improving its adhesion.

The silicon (Si) content in the solar cell encapsulating film is preferably 300 to 4,000 ppm, more preferably 400 to 3,000 ppm, based on the weight of the solar cell encapsulating film. When the silicon (Si) content is within the range, it results in a solar cell encapsulating film, which has been stored or transported in a package conditioned to a given humidity, having sufficiently enhanced adhesion. The silicon (Si) content in the solar cell encapsulating film can be determined, for example, as follows: the film is decomposed by wet process, diluted with pure water to a given final volume, and subjected to quantification of silicon atom (unit: mg/l) with an ICP emission spectrometer (ICPS-8100, Shimadzu Corporation).

The solar cell encapsulating film used in the present invention may contain various additives such as crosslinking aids.

The solar cell encapsulating film may also contain a reaction accelerator for enhancing the reactivity of the adhesion promoter. However, in order to ensure stability during storage or transportation, it is preferable that the solar cell encapsulating film be substantially free from such a reaction accelerator. There is concern that when the reaction accelerator is added it reduces the weather resistance and insulating ability of the solar cell encapsulating film, leading to low photovoltaic efficiency. There are no particular limitations on the above reaction accelerator; conventional reaction accelerators known in the art can be employed. Specific examples thereof include silanol condensation catalysts such as dibutyl tin diacetate, dibutyl tin dilaurate, dibutyl tin octate, and a dioctyl tin dilaurate. As used herein, "substantially free from" means that the amount of the reaction accelerator is 0.05 weight parts or less, preferably 0.03 weight parts or less, most preferably 0 weight part, per 100 weight parts of the total resin constituting the solar cell encapsulating film.

The solar cell encapsulating film may contain a crosslinking agent. The crosslinking agent may increase the heat resistance and weather resistance of the solar cell encapsulating film by effecting crosslinking of the base resin. Organic peroxides that generate radicals at 100°C or higher are generally preferable. In particular, in view of stability upon blending, organic peroxides with a half life of 10 hour and a decomposition temperature of 70°C or higher are more preferable,

Examples of such organic peroxides include 2,5-dimethyl-2,5-di(t-butylperoxy)hexane, 3-di-t-butylperoxide, t-dicumylperoxide, 2,5-dimethyl-2,5-di(t-butylperoxy)hexyne, dicumylperoxide, α,α'-bis(t-butylperoxyisopropyl)benzene, n-butyl-4,4-bis(t-butylperoxy)butane, 2,2-bis(t-butylperoxy)butane, 1,1-bis(t-butylperoxy)cyclohexane, 1,1-bis(t-butylperoxy)3,3,5-trimethylcyclohexane, t-butylperoxybenzoate, and benzoylperoxide.

When the ethylene/a-olefin copolymer is employed as the base resin, the crosslinking agent content is preferably 0.1 to 3.0 weight parts, more preferably 0.2 to 2.0 weight parts, per 100 weight parts of the ethylene/a-olefin copolymer.

The crosslinking aid may increase the durability of the solar cell encapsulating film by enhancing the crosslinking reactivity of the base resin such as the ethylene/a-olefin copolymer. Examples of the crosslinking aid include trifunctional crosslinking aids such as triallyl isocyanurate and tryallylisocyanate, and trimethylolpropanetriacrylate.

Examples of other additives include colorants, UV absorbers, anti-aging agents, anti-tarnishing agents, heat resistance stabilizers, UV (weather resistance) stabilizers, and light stabilizers.

Examples of the coloring agents include inorganic pigments such as metal oxides and metal powders; and organic pigments such as azo pigments, phthalocyanine pigments, and acid or basic dye lakes.

Examples of the UV absorbers include benzophenones such as 2-hydroxy-4-octoxybenzophenone, 2-hydroxy-4-methoxy-5-sulfobenzophenone; benzotriazols such as 2-(2'-hydroxy-5-methylphenyl)benzotriazol; and hindered amines such as phenyl salicylate and p-t-butylphenylsalicylate.

Examples of the anti-aging agents include amine-based, phenol-based, bisphenyl-based, and hindered amine-based anti-aging agents. Specific examples thereof include di-t-butyl-p-cresol and bis(2,2,6,6-tetramethyl-4-piperazyl)sebacate. Examples of the UV (weather resistance) stabilizers include dibutylhydroxytoluene. In addition, hydroquinone, hydroquinone monomethyl ether, p-benzoquinone, methylhydroquinone, etc. may be added in order to enhance the stability of the base resin such as the ethylene/a-olefin copolymer.

Such a solar cell encapsulating film can be prepared by, for example, a process in which a resin composition containing the above components is melt-kneaded and extruded in sheet form with a T-die extruder (melt-kneading), or a process in which the melt resin is stretched into a film by being passed under rollers (calendering). The thickness of the solar cell encapsulating film is about 100 µm to about 2,000 µm, for example.

The solar cell encapsulating film may be embossed on the surface in order to improve cushioning in the heat curing step and to prevent sheet blocking during storage or transportation.

### 2. Package for Solar Cell Encapsulating Film

A package of the present invention includes a solar cell encapsulating film containing a silane compound and/or a silane-modified resin, and a package bag packaging the solar cell encapsulating film, wherein the absolute humidity inside the package is 3 to 8 g/m³.

The solar cell encapsulating film is rolled up or cut into sheets of predetermined size and stacked on top of one another, packaged with the package bag, and stored or transported in the form of a package whose internal humidity is set to a predetermined level. By keeping the humidity inside the package at an appropriate level, it is possible to suppress reactions of the adhesion promoter contained in the solar cell encapsulating film, as well as to allow the solar cell encapsulating film to exert sufficient adhesion upon manufacture of a solar cell module. The edges of the package may be sealed with an adhesive tape for, for example, enhancing air tightness.

The package bag preferably has high gas barrier ability and high moisture barrier ability in order to suppress volatilization of the crosslinking agent and additives and to keep the humidity and moisture content inside the package at suitable levels. Thus, the package bag preferably has a moisture permeability of 1 g/(24hr·m²) or less, more preferably 0.1 g/(24hr·m²) or less. Moisture permeability may be measured in accordance with JIS Z 0208 at 40°C and at 90% relative humidity.

The package bag preferably contains a polyolefin resin in view of its good gas barrier ability and good moisture barrier ability. The polyolefin resin may be a homopolymer or a copolymer of different comonomers. Examples of the polyolefin resin include polyethylene resins (including high-density polyethylene and low-density polyethylene), polypropylene resins, and ethylene/a-olefin copolymer resins.

The package bag may contain resins other than polyolefin resins. Examples of the other resins include polyesters.

In order to improve gas barrier ability and moisture barrier ability, the package bag is preferably a laminate sheet composed of a resin layer containing polyolefin resin and of an aluminum sheet. In this case, in order to prevent corrosion of the aluminum sheet, the edges of the aluminum sheet are preferably encapsulated in the resin layer without being exposed to the outside.

The polyolefin resin contained in the package bag preferably has heat sealability. The heat-sealing temperature (melt temperature) of the polyolefin resin is preferably 80°C to 160°C because in this temperature range the resin is hard to melt during storage or transportation and because heat sealing can be readily effected. Suitable polyolefin resins are low-density polyethylene and polypropylene in view of their good gas barrier ability and good heat sealability.

The thickness of the package bag is 50 to 200 µm in view of sheet strength, handleability, gas barrier ability, etc.

The package bag in which a solar cell encapsulating film is contained may be further sealed with an adhesion tape. The adhesion tape includes a base film, and an adhesive layer.

The adhesive layer of the adhesive tape includes an adhesion resin, and an adhesion promoter. Examples of the adhesion resin include acrylic, rubber, and silicon adhesion resins known in the art.

The acrylic adhesion resins and rubber adhesion resins are resins prepared by crosslinking base polymers with crosslinking agents. Examples of rubber polymers contained in the adhesion resins include isobutylene polymers. Examples of acrylic copolymers contained in the adhesion resins include acrylic copolymers having a repeating unit derived from n-butyl acrylate, isooctyl acrylate, 2-ethylhexyl acrylate, isononyl acrylate, ethyl acrylate or the like. Comonomers in the acrylic copolymers are components having a double bond in the molecule, specifically, vinyl acetate, acrylonitrile, styrene and the like.

The adhesive tape is obtained by, for example, mixing a base adhesion resin, an adhesion promoter, and optionally a solvent for adjusting viscosity, to prepare a coating solution; applying the coating solution onto a substrate such as paper or plastic film; arid drying the coating.

The thickness of the adhesive layer is, for example, preferably 5 to 50 µm, more preferably 10 to 30 µm. When the adhesive layer is too thin, it is difficult to establish a desired level of adhesion. On the other hand, when the adhesive layer is too thick, it becomes difficult to take out the solar cell encapsulating film from the package bag due to too high adhesion.

The absolute humidity inside the package is 3 to 8 g/m³. When the absolute humidity inside the package is within the range, the reactive groups of the silane compound and/or silane-modified resin contained in the solar cell encapsulating film are moderately activated by moisture. This makes it possible to prevent excessive reactions of the reactive groups during storage or transportation of the solar cell encapsulating film, as well as to allow the solar cell encapsulating film to exert sufficient adhesion. Moreover, upon manufacturing of a solar cell module, the solar cell encapsulating film exerts good adhesion. When the absolute humidity inside the package is too low, the reactive groups are not fully activated, making it difficult to allow the solar cell encapsulating film to exert adhesion. On the other hand, when the absolute humidity inside the package is too high, the reactive groups are excessively activated, resulting in the reduction in the adhesion of the solar cell encapsulating film. When the reactive groups are alkoxylsilyl groups and at the same time the absolute humidity inside the package is too high, the alkoxylsilyl groups are converted to stable siloxane bonds, resulting in the reduction in the adhesion of the solar cell encapsulating film.

For the reasons above, the package of the present invention exerts its effects more noticeably particularly where the package includes the solar cell encapsulating film made of an ethylene/a-olefin copolymer or a silane-modified resin in which an ethylene/α-olefin copolymer is partially or entirely modified with silane compound. The reason for this is that since solar cell encapsulating films containing the ethylene/a-olefin copolymer as the base resin show lower adhesion than those containing EVA as the base resin, there is a need to add an adhesion promoter such as a silane compound or silane-modified resin in order to compensate for the lack of adhesion.

The absolute humidity inside the package can be adjusted through the procedure described below, for example. For example, a solar cell encapsulating film placed under a dry atmosphere and a sufficient amount of humidity conditioning material, previously conditioned under an atmosphere of desired humidity, are sealed in a package bag under a dry atmosphere. In this way a necessary amount of moisture is generated from the humidity conditioning material and distributed in the package, whereby the absolute humidity inside the package can be adjusted within a desired range.

The absolute humidity inside the package can be measured by a method known in the art. There are no particular limitations on the measurement method; for example, a handy digital humidity sensor ("TRH-CH" Shinei Technology Ltd.) can be inserted in the package for the measurement of the absolute humidity.

In the package it is preferable to place a humidity conditioner for adjusting the humidity inside the package, together with a solar cell encapsulating film. The humidity conditioner is preferably non-reactive to additives such as crosslinking agents contained in the solar cell encapsulating film; specific examples thereof include B-type silica gel, calcium chloride and magnesium chloride.

Before being placed in the package, the humidity conditioner is preferably retained in an atmosphere of predetermined temperature and humidity for moisture content adjustment in order to keep the humidity inside the package in a suitable range. For example, it is preferable to employ a humidity conditioner whose moisture content has been adjusted by retaining it in an environment with a temperature 15°C to 30°C, more preferably 20°C to 25°C, and a relative humidity of 10% to 45%, more preferably 15% to 35%, for 24 hours or longer, more preferably 48 hours or longer.

The amount of the humidity conditioner placed in the package is appropriately adjusted depending on the size of the internal space of the package, the amount of the solar cell encapsulating film to be placed in the package, and the amount of additives and adhesion promoter contained in the solar cell encapsulating film.

There are no particular limitations on the method of manufacturing the package; the package can be manufactured by any method known in the art. Examples of the method of manufacturing the package include a method in which a stack of solar cell encapsulating films is packaged with a package bag followed by sealing of the opening of the package bag by heat sealing or with an adhesive tape, and a method in which a stack of solar cell encapsulating films is placed in a bottom-sealed package bag followed by sealing of the opening by heat sealing or with an adhesive tape.

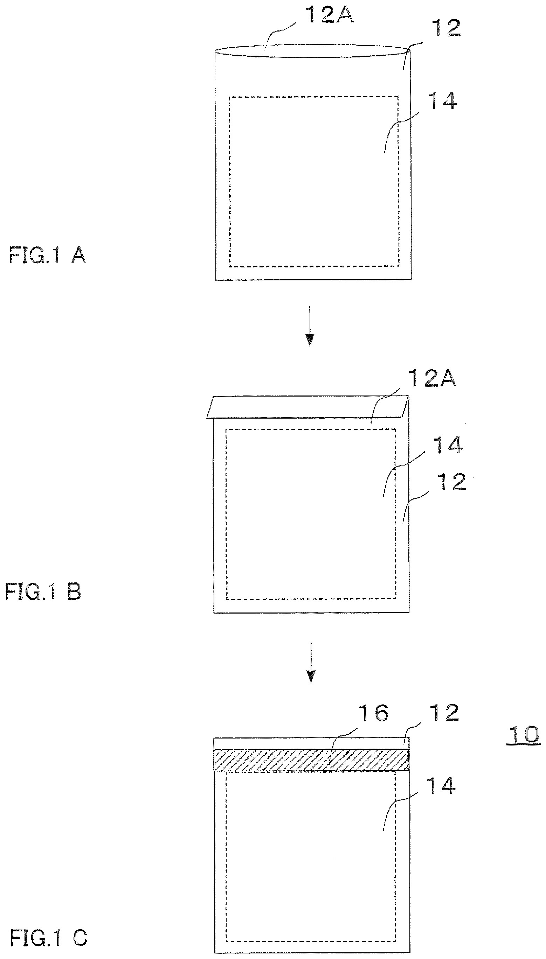

Figs.1A to 1C are schematic views illustrating an example of a method of manufacturing a package according to an embodiment of the present invention. As illustrated in Fig.lA, package bag 12 in the form of bottom-sealed bag is prepared, and solar cell encapsulating film 14 is placed therein. Next, as illustrated in Fig.1B, the edge of package bag 12 on opening 12A side is folded back in such a way that the folded edge does not overlap the solar cell encapsulating films as much as possible. As illustrated in Fig.1C, the folded edge is then sealed with adhesive tape 16. In this way package 10 is manufactured. The adhesive tape is applied to package bag 12 in a region right next to the edge of solar cell encapsulating film 14.

The package thus manufactured is preferably transported or stored in a dark environment. The dark environment is preferably an environment which is not subjected to direct sunlight and has a temperature 30°C or less, preferably 25°C or less. For improved heat insulation, the package is preferably packaged in a container such as a cardboard box for storage or transportation. The package is preferably stored or transported in a dark environment for 50 hours or longer, more preferably 100 hours or longer. By storing or transporting the package for 50 hours or longer in a dark environment, the adhesion of the solar cell encapsulating film is kept at a high level by the moisture inside the package.

### 3. Solar Cell Module

The solar cell encapsulating film stored or transported as described above is suitably used as a member (layer) for encapsulating solar cells of a solar cell module. Solar cells come in a variety of types, including silicon (e.g., crystalline silicone and thin-film silicon) solar cells, compound (e.g., CIGS) solar cells, and organic (e.g., dye-sensitized) solar cells. The following description is directed to a solar cell module where silicon solar cells are used.

### (1) Crystalline Silicon Solar Cell Module

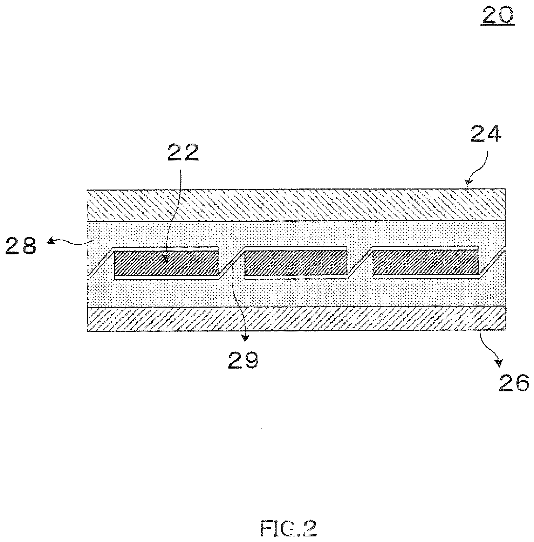

Fig.2 is a cross-sectional view illustrating an example of a configuration of a silicon solar cell module. As illustrated in Fig.2, solar cell module 20 includes a plurality of crystalline silicon solar cells 22 electrically interconnected via interconnectors 29, and a pair of front protective member 24 and back protective member 26 which are opposite each other for sandwiching solar cells 22. Encapsulating layer 28 fills the space between these protective layers and between solar cells 22. Encapsulating layer 28 is produced by laminating together solar cell encapsulating films, and contacts electrodes respectively formed on the light-incident surface and back surface of each solar cell 22. These electrodes are current collectors respectively formed on the light-incident surface and back surface of each solar cell 22, and each includes collector lines, tab-type busbars, back electrode layer, etc., later described.

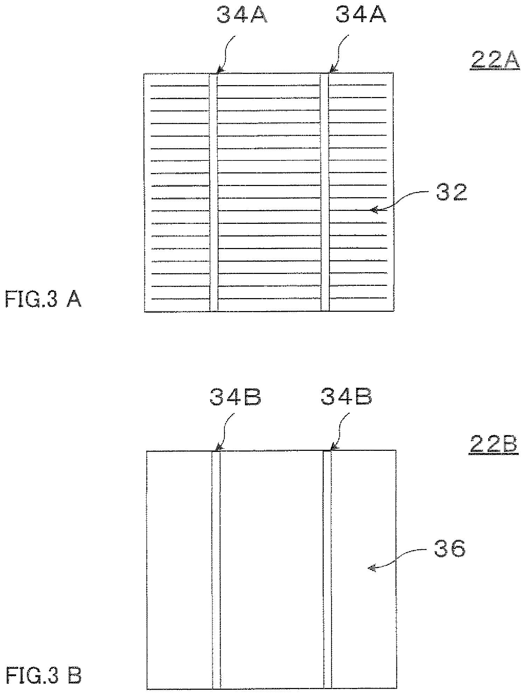

Fig.3 is a plan view illustrating an example of a configuration of the light-incident surface or back surface of the solar cell. As illustrated in Fig.3A, solar cell 22 includes on light-incident surface 22A multiple collector lines 32 and tab-type busbars 34A that are connected to interconnectors 29 (see Fig.2) and collect electrical charges from collector lines 32.

As illustrated in Fig.3B, solar cell 22 includes conductive layer (back electrode) 36 formed on the entire surface of back surface 22B, and tab-type busbars 34B are formed thereon that are connected to interconnectors 29 (see Fig.2) and collect electrical charges from conductive layer 36.

The line width of collector lines 32 is, for example, about 0.1 mm, the line width of tab-type busbars 34A is, for example, about 2 mm to about 3 mm, and the line width of tab-type busbars 34B is, for example, about 5 mm to about 7 mm. The thickness of collector lines 32, tab-type busbars 34A and tab-type busbars 34B is, for example, about 20 µm to about 50 µm.

Collector lines 32, tab-type busbars 34A and tab-type busbars 34B preferably contain a metal with high conductivity. Examples of metals with high conductivity include gold, silver and copper, with silver, silver compounds and silver-containing alloys being preferable for their high conductivity and high corrosion resistance.

Conductive layer 36 preferably contains not only a metal with high conductivity, but also a component with high light reflectivity, such as aluminum, for reflecting light received at the light-incident surface to enhance the opto-electronic conversion efficiency.

Collector lines 32, tab-type busbars 34A, tab-type busbars 34B and conductive layer 36 are formed by depositing a conductive material solution containing the conductive metal onto either light-incident surface 22A or back surface 22B of solar cell by, for example, screen printing to a thickness of 50 µm, drying the deposited coating and, where necessary, baking the coating at 600°C to 700°C.

Transparent front protective member 24 needs to be transparent as it is placed on the light-incident surface side of solar cell 22. Examples of transparent front protective member 24 include transparent glass plates and transparent resin films. Back protective member 26, on the other hand, needs not to be transparent, and the material thereof is not particularly limited. Examples of back protective member 26 include glass substrates and plastic films, with glass substrates being suitable for high resistance and transparency.

Solar cell module 20 can be obtained by any manufacturing process. Solar cell module 20 can be obtained by, for example, a manufacturing process including the steps of: obtaining a stack in which module components are stacked in the order of back protective member 26, solar cell encapsulating film, solar cells 22, solar cell encapsulating film, and transparent front protective member 24; pressing the stack with a laminator or the like optionally with heating for integration of the module components to obtain a laminate; and optionally heating the laminate to cure the encapsulating films by effecting crosslinking reactions.

The heating/pressing condition varies depending on the type of the solar cell encapsulating film; for example, heating/pressing temperature is set to 130°C, heating/pressing is performed under vacuum condition for 3 minutes, and under pressure condition for 4 minutes. Mainly in order to crosslink a resin composing the solar cell encapsulating films, heating/pressing temperature is set to 150°C and heating/pressing time is set to 40 minutes, for example.

### (2) Thin-film Silicon (Amorphous Silicon) Solar Cell Module

A thin-film silicon solar cell module may be configured as 1) a stack in which module components are stacked in the order of a transparent front protective member (glass substrate), thin-film solar cells, encapsulating layer, and back protective member; 2) a stack in which module components are stacked in the order of transparent front protective layer, encapsulating layer, thin-film solar cells, encapsulating layer, and back protective layer; or the like. The transparent front protective member, back protective member and encapsulating layer are identical to those for the crystalline silicon solar cell module described above.

A thin-film silicon solar cell of a thin-film silicon solar cell module with configuration 1) includes, a transparent electrode layer, a silicon p-i-n layer, and a back electrode layer, in this order, for example. Examples of materials of the transparent electrode layer include semiconductor oxides, such as In₂O₃, SnO₂, ZnO, Cd₂SnO₄, and ITO (In₂O₃ doped with Sn). The back electrode layer includes a silver thin film layer, for example. Each layer is formed by plasma chemical vapor deposition (CVD) or sputtering.

The encapsulating layer is placed so as to contact the back electrode layer (e.g., silver thin film layer). Since the transparent electrode layer is formed on the transparent front protective member, it is often the case that the encapsulating layer is not provided between the front protective layer and transparent electrode layer.

A thin-film silicon solar cell of a thin-film solar cell module with configuration 2) includes, a transparent electrode layer, a silicon p-i-n layer, and a metal foil or thin metal layer (e.g., silver thin film layer) formed on a heat-resistant polymer film, in this order, for example. Examples of the metal foil include stainless steel foil. Examples of the heat-resistant polymer film include polyimide films.

The transparent electrode layer and silicon p-i-n layers are formed by CVD or sputtering as with those described above. That is, the silicon p-i-n layer is formed on the metal foil or the thin metal layer formed on the heat-resistant polymer film, and the transparent electrode layer is formed on the silicon p-i-n layer. The thin metal layer formed on the heat-resistant polymer film may also be formed by CVD or sputtering.

In this case, the encapsulating layer is placed between the transparent electrode layer and the front protective member, and between the metal foil or heat-resistant polymer film and the back protective member.

As described above the encapsulating layer formed of a solar cell encapsulating film contacts electrodes of solar cells, such as collector lines, tab-type busbars, and conductive layer.

Thin-film silicon solar cells of a crystalline silicon solar cell module with configuration 1) have silicon layers that are thinner than those in crystalline silicon solar cells of a crystalline silicon solar cell module and thus are less prone to breakage by the pressure applied during the manufacture of the solar cell module or by external impact during operation. For this reason, solar cell encapsulating films for thin-film silicon solar cell modules may be less flexible than those for crystalline silicon solar cell modules. On the other hand, since the electrodes of thin-film solar cells are formed of metal thin film layers, there is fear that power generation efficiency significantly decreases when they are degraded by corrosion. Accordingly, ethylene/a-olefin copolymers, which are less flexible than EVA but do not necessarily require a crosslinking agent which causes cracked gas, are suitably used in solar cell encapsulating films for thin-film solar cell modules with configuration (2).

### Examples

### 1. Methods of Measuring Physical Properties

### (1) Density

A strand subjected measurement of melt flow rate (MFR2) is allowed to cool to room temperature over 1 hour, followed by measurement of density (kg/cm³) by the density gradient tube method.

### (2) Peak Melt Temperature

A DSC aluminum sample pan is loaded with approximately 5 mg of sample and, in a differential scanning calorimeter (PerkinElmer DSC7), (i) heated from 0°C to 200°C at a heating rate of 320°C/min, (ii) retained at 200°C for 5 minutes, (iii) cooled from 200°C to 0°C at a cooling rate of 10°C/min, (iv) retained at 0°C for 5 minutes, and (v) heated at a heating rate of 10°C/min. In this way an endothermic curve is obtained. The peak top temperature in the obtained DSC endothermic curve is defined as peak melt temperature. It should be noted that when multiple peaks appeared by DSC, the endothermic peak observed at the highest temperature is employed as peak melt temperature (°C).

### (3) MFR2

MFR2 (g/10min) is measured in accordance with JIS K-6721 at 190°C under a load of 2.16 kg.

### (4) Molecular Weight Distribution (Mw/Mn)

The molecular weight distribution (Mw/Mn) is measured on a gel permeation chromatograph using Waters Alliance GPC 2000 under the following conditions:
Separation columns: TSKgel GNH6-HT (Tosoh Corporation) (x2), SKgel GNH6-HTL (Tosoh Corporation) (x2)
Column size: 7.5 mm in diameter and 300 mm in length
Column temperature: 140°C
Mobile phase: o-dichlorobenzene (Wako Pure Chemical Industries, Ltd.) with 0.025 wt% antioxidant BHT (Takeda Pharmaceutical Company Ltd.)
Mobile phase flow rate: 1.0 ml/min
Sample concentration: 15 mg / 10ml
Sample injection volume: 500 µl
Detector: differential refractometer
Standard polystyrenes (Mw<1,000, Mw>4x10⁶): standard polystyrene available from Tosoh Corporation
Standard polystyrene (1000≤Mw≤4x10⁶): standard polystyrene available from Pressure Chemical Company

### (5) Metal Residue Content

An ethylene polymer is decomposed by wet process and diluted with pure water to a given final volume, and the amounts of aluminum, zirconium, titanium, hafnium and magnesium are quantified with an ICP emission spectrometer (ICPS-8100, Shimadzu Corporation), with the total amount of the metal elements defined as metal residue content (ppm).

### (6) Moisture Content in Package

First, absolute humidity (g/m³) is calculated from the temperature and relative humidity with reference to a psychrometric chart. Moisture content is then found by multiplying absolute humidity (g/m³) by internal volume (L) of the package.

### 2. Synthesis Examples

### (Synthesis Example 1) Ethylene Polymer (A)

### 1. Preparation of Solid Catalyst Component

A solid catalyst component which contains dimethylsilylene bis(3-methylcyclopentadienyl)zirconium dichloride, a metallocene compound, is prepared in accordance with the procedure described in JP-A No.09-328520. The zirconium content per gram of the solid catalyst component is 2.3 mg.

### 2. Preparation of Prepolymerized Catalyst

In accordance with the procedure described in JP-A No.09-328520, a prepolymerized catalyst in which 3 g of ethylene polymer is prepolymerized is obtained using 4 g of the above solid catalyst component, 1-hexene, and ethylene. The zirconium content per gram of the prepolymerized catalyst component is 2.2 mg.

### 3. Polymerization

A stainless-steel autoclave with an interior volume 2L, which is fully purged with nitrogen gas, is charged with 800 ml of hexane purified by dehydration, and the system is purged with ethylene/hydrogen mixture gas (hydrogen content: 0.7 mol%). The system is heated to 60°C and charged with 1.5 mmol of triisobutylaluminum, 200 ml of 1-hexene, and 0.015 mg in terms of zirconium atom of the above prepolymerized catalyst.

Ethylene/hydrogen mixture gas (hydrogen content: 0.7 mol%) is introduced to a total pressure of 3 MPa, and polymerization is effected. While supplying the mixture gas to keep the total pressure at 3 MPa, the polymerization reaction is carried out at 70°C for 1.5 hours. After the polymerization reaction, the resultant solid is filtered off and dried at 80°C overnight to afford 101 g of ethylene polymer (A). Measured values of density, MFR2, Mw/Mw and metal residue content of ethylene polymer (A) are given in Table 1.

The above polymerization procedure is repeated. Ethylene polymer (A) is extruded with a single screw extruder from TPIC Co., Ltd. (screw diameter=20mm ϕ, L/D=28) at die temperature of 190°C to produce a pellet of ethylene polymer (A) (ethylene polymer (A)P).

### (Synthesis Example 2) Ethylene polymer (B)

130 g of ethylene polymer (B) is prepared in the same manner as described in the above section titled "3. Polymerization" except that the hydrogen content in the ethylene/hydrogen mixture gas is changed to 0.5 mol%, that the amount of hexane is changed to 870 ml and that the amount of 1-hexene is changed to 230 ml. Measured values for density, MFR2, Mw/Mw and metal residue content of ethylene polymer (B) are given in Table 1. The same polymerization procedure is repeated, and resultant ethylene polymer (B) is extruded with the single-screw extruder to produce a pellet of ethylene polymer (B) (ethylene polymer (B)P).

### (Synthesis Example 3) Modified Product (1) of Ethylene polymer (B)

50 weight parts of ethylene polymer (B), 50 weight parts of ethylene polymer (B)P, 1.3 weight parts of maleic anhydride (radically polymerizable unsaturated compound), and 0.1 weight parts of 2,5-dimethyl-2,5-di(t-butylperoxy)hexane (organic peroxide) are dry-blended. The blended mixture is extruded with a single screw extruder from TPIC Co., Ltd. (screw diameter=20mm ϕ, L/D=28) at die temperature of 210°C to produce a pellet of modified product (1) of ethylene polymer (B) (modified product (1)P of ethylene polymer (B)).

**Table 1**

| | Ethylene Polymer (A) | Ethylene polymer (B) |
|---|---|---|
| Density (kg/cm³) | 903 | 901 |
| Melt peak temperature (°C) | 98 | 96 |
| MFR2 (g/10min) | 3.8 | 3.5 |
| Mw/Mn | 2.1 | 2.1 |
| Metal residue (weightppm) | 10 | 12 |

### 3. Manufacture and Storage of Package

### (Example 1)

### (1) Silane Modification and Sheet Molding

90 weight parts of ethylene polymer (A)P and 10 parts weight of ethylene polymer (B)P are dry-blended. To the polymer blend thus obtained is added 0.5 weight parts of γ-methacryloxpropyltrimethoxysilane (ethylenically-unsaturated silane compound), 0.05 weight parts of 2,5-dimethyl-2,5-di(t-butylperoxy)hexane (organic peroxide), 0.4 weight parts of 2-hydroxy-4-n-octyloxybenzophenone (UV absorber), 0.1 weight parts of bis(2,2,6,6-tetramethyl-4-piperidyl)sebacate (radical scavenger), and 0.1 weight parts of tris(2,4-di-tert-buthylphenyl)phosphite (heat resistance stabilizer), and dry-blended to produce an ethylene polymer blend.

Using a single screw extruder from TPIC Co., Ltd. (screw diameter = 20mm ϕ, L/D=28) equipped with a coat hanger-type T-die (lip shape; 270 x 0.8 mm), the ethylene polymer blend is extruded in sheet form at die temperature of 210°C, cooled on a chill roll whose temperature is 30°C, and taken up on at a take up rate of 1.0 m/min. In this way a sheet of solar cell encapsulating film of 500 µm thickness is obtained, which is made from a resin composition containing the modified product modified with the ethylenically-unsaturated silane compound (silane-modified resin). The solar cell encapsulating film is engraved with a diamond-grid pattern (130 µm x 130 µm x 60 µm depth) on the surface. The Si content in the solar cell encapsulating film as measured with an ICP emission spectrometer in the same manner as that for the quantification of metal residue content is 420 ppm.

### (2) Storage

The solar cell encapsulating film is cut to a length of 2,000 cm and width of 60 cm and wound around a paper tube (tube diameter=7.6cm) to produce a roll. The roll thus obtained and 100 g of B-type silica gel (humidity conditioner) which has been allowed to stand for 40 hours at 23°C and at 25% relative humidity are placed in a 80µm-thick moisture-proof bag at 25% relative humidity ("A-type moisture-proof aluminum bag" manufactured by ADY Co., Ltd.; moisture permeability: 0.38g /24hr·m²), a package bag formed of a polyethylene terephthalate film (12 µm) / polyethylene film (15 µm) / aluminum sheet (7 µm) / polyethylene film (15 µm) / linear low-density polyethylene film (30 µm) stack. The opening of the package bag is folded back (see Figs.1A and 1B), and the folded edge is sealed by heat sealing at 180°C for 1 second to produce a package (see Fig.1C). The absolute humidity inside the package is 5.2 g/m³ and the relative humidity is 25%. The volume of the solar cell encapsulating film in the package is 5.4L, and the internal volume of the package bag excluding the solar cell encapsulating film is 13.9L.
The package is stored for 100 hours in an environment of 40% relative humidity.

### (Example 2)

A package is prepared as in Example 1 except that the absolute humidity inside the package is set to 7.3 g/m³ (35% relative humidity) and that as a humidity conditioner 100 g of B-type silica gel which has been allowed to stand for 40 hours at 23°C and at 35% relative humidity is used. The package is stored under the same condition as that in Example 1 except that storage time is set to 1,000 hours.

### (Example 3)

A package is prepared as in Example 1 except that the absolute humidity inside the package is set to 2.9 g/m³ (15% relative humidity) and that as a humidity conditioner 100 g of B-type silica gel which has been allowed to stand for 40 hours at 23°C and at 15% relative humidity is used. The package is stored under the same condition as that in Example 1.

### (Comparative Example 1)

A package is prepared as in Example 1 except that the absolute humidity inside the package is set to 0.0 g/m³ (<2.5% relative humidity) and that as a humidity conditioner 100 g of calcium oxide is used. The package is stored under the same condition as that in Example 1.

### (Comparative Example 2)

A package is prepared as in Comparative Example 1. The package is stored under the same condition as that in Example 1 except that storage time is set to 1,000 hours.

### (Comparative Example 3)

A package is prepared as in Example 1 except that the absolute humidity inside the package is set to 17.3 g/m³ (60% relative humidity) and that as a humidity conditioner 100 g of B-type silica gel which has been allowed to stand for 40 hours at 23°C and at 60% relative humidity is used. The package is stored under the same condition as that in Example 1.

### (Example 4)

A package is prepared as in Example 1 except that placing a film formed from a polymer blend obtained by dry-blending 80 weight parts of ethylene polymer (B)P and 20 weight parts of modified product (1)P of ethylene polymer (B) is used. The package is stored under the same condition as that in Example 1.

### (Example 5)

A package is prepared as in Example 4 except that the absolute humidity inside the package is set to 7.3 g/m³ (35% relative humidity) and that as a humidity conditioner 100 g of B-type silica gel which has been allowed to stand for 40 hours at 23°C and at 35% relative humidity is used. The package is stored under the same condition as that in Example 4 except that storage time is set to 1,000 hours.

### (Comparative Example 4)

A package is prepared as in Example 4 except that the absolute humidity inside the package is set to 0.0 g/m³ (<2.5% relative humidity) and that as a humidity conditioner 100 g of calcium oxide is used. The package is stored under the same condition as that in Example 4.

### (Comparative Example 5)

A package is prepared as in Comparative Example 4. The package is stored under the same condition as that in Example 4 except that storage time is set to 1,000 hours.

### (Comparative Example 6)

A package is prepared as in Example 4 except that the absolute humidity inside the package is set to 17.3 g/m³ (60% relative humidity) and that as a humidity conditioner 100 g of B-type silica gel which has been allowed to stand for 40 hours at 23°C and at 60% relative humidity is used. The package is stored under the same condition as that in Example 4.

### 4. Evaluation of Solar Cell Encapsulating Film

### Evaluation of Peel Strength

Peel strength (initial peel strength and post 500 hour-acceleration test peel strength) is measured for the solar cell encapsulating films taken out from the stored package bodies of Examples 1 to 5 and Comparative Examples 1 to 6. Peel strength is measured in the manner described below. Measured values for peel strength are given in Tables 2 and 3.

### (1) Peel Strength (initial)

The 0.5mm-thick solar cell encapsulating film is placed on a transparent glass plate, and the stack is loaded on a hot plate (set to 150°C) in a vacuum laminator. The stacked components are laminated under vacuum for 2 seconds and heated for 6 minutes to fabricate a transparent glass plate/solar cell encapsulating film laminate. The laminate is cut to a width of 15 mm, and peel strength (initial) of the solar cell encapsulating film is measured. As peel strength, a 180 degree peel strength is measured at 23°C with Instron 1123 tensile tester at a 30 mm span and a 30 mm/min crosshead speed, and an average of three measured values is taken as peel strength.

### (2) Peel Strength (after 500 hour-acceleration test)

The laminate from the above peel strength (initial) test is subjected to a 500 hour-acceleration test in accordance with JIS C8917 using custom-made XL75 (xenon weather meter from Suga Test Instruments Co., Ltd.) at a test chamber temperature of 85°C and a humidity of 85%. Peel strength (post 500 hour-acceleration) is then measured for the laminate in the same manner as that used in the above peel strength (initial) test.

**Table 2**

| | | Ex. 1 | Ex. 2 | Ex. 3 | Comp. Ex. 1 | Comp. Ex. 2 | Comp. Ex. 3 |
|---|---|---|---|---|---|---|---|
| Internal environment of package | Relative humidity (%RH) | 25 | 35 | 15 | <2.5 | <2.5 | 60 |
| | Solar cell encapsulating film's volume (L) | 5.4 | 5.4 | 5.4 | 5.4 | 5.4 | 5.4 |
| | Internal volume of package excluding solar cell encapsulating film (L) | 13.9 | 13.9 | 13.9 | 13.9 | 13.9 | 13.9 |
| | Number of moles of reactive groups of polymerizable silane compound (mol) | 0.26 | 0.26 | 0.26 | 0.26 | 0.26 | 0.26 |
| | Moisture content (g) | 0.07 | 0.10 | 0.04 | 0 | 0 | 0.17 |
| | Absolute humidity (g/m³) | 5.2 | 7.3 | 2.9 | 0.0 | 0.0 | 17.3 |
| Storage condition | Relative humidity (%RH) | 40 | 40 | 40 | 40 | 40 | 40 |
| | Temperature (°C) | 23 | 23 | 23 | 23 | 23 | 23 |
| | Storage time (hr) | 100 | 1000 | 100 | 100 | 1000 | 100 |
| Peel strength (N/cm) | Initial | >10 | >10 | >10 | <1 | <1 | <1^{note1} |
| | After 500 hour-acceleration test | >10 | >10 | >10 | >10 | >10 | <1^{note1} |

**Table 3**

| | | Ex. 4 | Ex. 5 | Comp. Ex. 4 | Comp. Ex. 5 | Comp. Ex. 6 |
|---|---|---|---|---|---|---|
| Internal environment of package | Relative humidity (%RH) | 25 | 35 | <2.5 | <2.5 | 60 |
| | Solar cell encapsulating film's volume (L) | 5.4 | 5.4 | 5.4 | 5.4 | 5.4 |
| | Internal volume of package excluding solar cell encapsulating film (L) | 13.9 | 13.9 | 13.9 | 13.9 | 13.9 |
| | Number of moles of reactive groups of polymerizable silane compound (mol) | 0.26 | 0.26 | 0.26 | 0.26 | 0.26 |
| | Moisture content (g) | 0.07 | 0.10 | 0 | 0 | 0.17 |
| | Absolute humidity (g/m³) | 5.2 | 7.3 | 0.0 | 0.0 | 17.3 |
| Storage condition | Relative humidity (%RH) | 40 | 40 | 40 | 40 | 40 |
| | Temperature (°C) | 23 | 23 | 23 | 23 | 23 |
| | Storage time (hr) | 100 | 1000 | 100 | 1000 | 100 |
| Peel strength (N/cm) | Initial | >10 | >10 | 2 | 2 | <1^{note1} |
| | After 500 hour-acceleration test | >10 | >10 | >10 | >10 | <1^{note1} |

As seen from Tables 2 and 3, values of peel strength (initial) of the solar cell encapsulating films taken out from the package bodies of Examples 1 to 5 are higher than those of the solar cell encapsulating films taken out from the package bodies of Comparative Examples 1 to 6.

Values of peel strength (post 500 hour-acceleration) of the solar cell encapsulating films taken out from the package bodies of Examples 1 to 5 and Comparative Examples 1, 2, 4 and 5 are high enough. The high values of peel strength (post 500 hour-acceleration) of the solar cell encapsulating films taken out from the package bodies of Comparative Examples 1, 2, 4 and 5 may be due to the following reason: Because the inside of the package bodies of Comparative Examples 1, 2, 4 and 5 is dried, the adhesion promoter and other components that contribute to adhesion do not undergo reactions immediately after the solar cell encapsulating film has been taken out from the package, and therefore, the solar cell encapsulating film shows poor adhesion. However, after the 500 hour-acceleration test, the adhesion promoters and the like undergo reactions to alter the structure of the solar cell encapsulating film in such a way that it can exert its adhesion.

The solar cell encapsulating films taken out from the package bodies of Comparative Examples 3 and 6 ruptured upon separation from the transparent glass substrate for measurement of peel strength. This may be due to too high humidity inside the package during storage, which hardens the solar cell encapsulating film to reduce flexibility.

### Industrial Applicability

The present invention can suppress reduction in the adhesion of a solar cell encapsulating film during storage or transportation, allowing the solar cell encapsulating film to exert sufficient adhesion upon manufacturing of a solar cell module. Thus, by using the package of the present invention, it is possible to provide a solar cell encapsulating film with which a solar cell module can be manufactured in which breakage of solar cells and electrode corrosion by seep water are avoided. It is also possible to avoid the poor appearance of the solar cell module or reduction in the power generation efficiency.

### Reference Signs List

- 10: Package
- 12: Package Bag
- 12A: Opening
- 14: Solar Cell Encapsulating Film
- 16: Adhesive Tape
- 20: Solar Cell Module
- 22: Solar Cell
- 22A: Light-incident Surface
- 22B: Back Surface
- 24: Transparent front Protective Member
- 26: Back Protective Member
- 28: Encapsulating Layer
- 29: Interconnector
- 32: Collector Line
- 34A, 34B: Tab-type Busbar
- 36: Conductive layer

## Claims

1. A package (10) comprising:
a solar cell encapsulating film (14) containing a silane compound and/or a silane-modified resin; and
a package bag (12) packaging the solar cell encapsulating film (14), the package bag suitable for storing or transporting a solar cell encapsulating film,
wherein an absolute humidity inside the package (10) is 3 to 8 g/m³.

2. The package (10) according to claim 1, wherein a base component of the solar cell encapsulating film (14) is an ethylene/α-olefin copolymer.

3. The package (10) according to claim 2, wherein the ethylene/α-olefin copolymer satisfies the following requirements a) to e):
a) Density = 900 to 940 kg/m³;
b) Peak melt temperature as measured by differential scanning calorimetry (DSC) = 90°C to 125°C;
c) Melt flow rate (MFR2) as measured at 190°C under a load of 2.16 kg = 0.1 to 100 g/10min;
d) Mw/Mn ratio = 1.2 to 3.5; and
e) Metal residue content = 50 weight ppm or less.

4. The package (10) according to claim 1, wherein the silane compound and/or the silane-modified resin have an alkoxysilyl group.

5. The package (10) according to claim 2, wherein an amount of the silane compound contained in the solar cell encapsulating film (14) is 0.1 to 3.0 weight parts per 100 weight parts of the ethylene/α-olefin copolymer.

6. The package (10) according to claim 2, wherein the silane-modified resin is a modified product obtainable by grafting 100 weight parts of the ethylene/α-olefin copolymer with 0.1 to 5 weight parts of a polymerizable silane compound.

7. The package (10) according to claim 1, wherein a silicon (Si) atom content in the solar cell encapsulating film (14) is 300 to 4,000 ppm based on a weight of the solar cell encapsulating film (14) .

8. The package (10) according to claim 1, wherein package (10) comprises a stack of the plurality of solar cell encapsulating films (14).

9. The package (10) according to claim 1, wherein the package bag (12) contains a polyolefin resin.

10. The package (10) according to claim 1, wherein the package bag (12) has a moisture permeability of 1 g/(24hr·m²) or less.

11. The package (10) according to claim 1, further comprising a humidity conditioner inside the package (10).

12. The package (10) according to claim 11, wherein the humidity conditioner is at least one member selected from the group consisting of silica gel, calcium chloride and magnesium chloride.

13. A method of storing or transporting a solar cell encapsulating film (14) containing a silane compound and/or a silane-modified resin, the method comprising:
packaging the solar cell encapsulating film (14) with a package bag (12) to provide a package (10) having an internal absolute humidity of 3 to 8 g/m³; and
storing or transporting the solar cell encapsulating film (14) in a dark environment for 50 hours or longer.

## Patentansprüche

1. Packung (10), umfassend:
einen Solarzellen-Einkapselungsfilm (14), der eine Silanverbindung und/oder ein silanmodifiziertes Harz enthält; und
eine Packungstasche (12), die den Solarzellen-Einkapselungsfilm (14) verpackt, wobei die Packungstasche zum Lagern oder Transportieren eines Solarzellen-Einkapselungsfilms geeignet ist;
wobei eine absolute Feuchtigkeit in der Packung (10) 3 bis 8 g/m³ beträgt.

2. Packung (10) gemäß Anspruch 1, wobei eine Basiskomponente des Solarzellen-Einkapselungsfilms (14) ein Ethylen/α-Olefin-Copolymer ist.

3. Packung (10) gemäß Anspruch 2, wobei das Ethylen/α-Olefin-Copolymer die folgenden Anforderungen a) bis e) erfüllt:
a) Dichte = 900 bis 940 kg/m³;
b) Spitzenschmelztemperatur gemessen durch dynamische Differenzkalorimetrie (DSC) = 90°C bis 125°C;
c) Schmelzflussrate (MFR2) gemessen bei 190°C unter einer Last von 2,16 kg = 0,1 bis 100 g/10 min;
d) Mw/Mn-Verhältnis = 1,2 bis 3,5; und
e) Metallrückstandsgehalt = 50 Gewichts-ppm oder weniger.

4. Packung (10) gemäß Anspruch 1, wobei die Silanverbindung und/oder das silanmodifizierte Harz eine Alkoxysilylgruppe aufweisen.

5. Packung (10) gemäß Anspruch 2, wobei eine Menge der Silanverbindung, die in dem Solarzellen-Einkapselungsfilm (14) enthaltenen ist, 0,1 bis 3,0 Gewichtsteile pro 100 Gewichtsteile des Ethylen/α-Olefin-Copolymers beträgt.

6. Packung (10) gemäß Anspruch 2, wobei das silanmodifizierte Harz ein modifiziertes Produkt ist, das durch Pfropfen von 100 Gewichtsteilen des Ethylen/α-Olefin-Copolymers mit 0,1 bis 5 Gewichtsteilen einer polymerisierbaren Silanverbindung erhältlich ist.

7. Packung (10) gemäß Anspruch 1, wobei ein Silicium (Si)-Atomgehalt in dem Solarzellen-Einkapselungsfilm (14) 300 bis 4.000 ppm, bezogen auf ein Gewicht des Solarzellen-Einkapselungsfilms (14), beträgt.

8. Packung (10) gemäß Anspruch 1, wobei die Packung (10) einen Stapel von mehreren Solarzellen-Einkapselungsfilmen (14) umfasst.

9. Packung (10) gemäß Anspruch 1, wobei die Packungstasche (12) ein Polyolefinharz enthält.

10. Packung (10) gemäß Anspruch 1, wobei die Packungstasche (12) eine Feuchtigkeitsdurchlässigkeit von 1 g/(24 h·m²) oder weniger aufweist.

11. Packung (10) gemäß Anspruch 1, zusätzlichen umfassend einen Feuchtigkeitskonditionierer innerhalb der Packung (10) .

12. Packung (10) gemäß Anspruch 11, wobei der Feuchtigkeitskonditionierer mindestens ein Mitglied ist, das aus der Gruppe ausgewählt ist, die aus Kieselgel, Calciumchlorid und Magnesiumchlorid besteht.

13. Verfahren zum Lagern oder Transportieren eines Solarzellen-Einkapselungsfilms (14), der eine Silanverbindung und/oder ein silanmodifiziertes Harz enthält, wobei das Verfahren umfasst:
das Verpacken des Solarzellen-Einkapselungsfilms (14) mit einer Packungstasche (12), um eine Packung (10) mit einer inneren absoluten Feuchtigkeit von 3 bis 8 g/m³ bereitzustellen; und
das Lagern oder Transportieren des Solarzellen-Einkapselungsfilms (14) in einer dunklen Umgebung für 50 Stunden oder länger.

## Revendications

1. Emballage (10) comprenant :
un film d'encapsulation de cellule solaire (14) contenant un composé de silane et/ou une résine modifiée au silane ; et
un sac d'emballage (12) emballant le film d'encapsulation de cellule solaire (14), le sac d'emballage étant adapté pour stocker ou transporter un film d'encapsulation de cellule solaire,
dans lequel une humidité absolue à l'intérieur de l'emballage (10) est de 3 à 8 g/m³.

2. Emballage (10) selon la revendication 1, dans lequel un composant de base du film d'encapsulation de cellule solaire (14) est un copolymère d'éthylène/α-oléfine.

3. Emballage (10) selon la revendication 2, dans lequel le copolymère d'éthylène/α-oléfine satisfait aux exigences suivantes a) à e) :
a) densité = 900 à 940 kg/m³ ;
b) température pic-état fondu mesurée par calorimétrie différentielle à balayage (DSC) = 90 °C à 125 °C ;
c) indice de fluidité (MFR2) mesuré à 190 °C sous une charge de 2,16 kg = 0,1 à 100 g/10 min ;
d) rapport Mw/Mn = 1,2 à 3,5 ; et
e) teneur en résidu métallique = 50 ppm en poids ou moins.

4. Emballage (10) selon la revendication 1, dans lequel le composé de silane et/ou la résine modifiée au silane présentent un groupe alcoxysilyle.

5. Emballage (10) selon la revendication 2, dans lequel une quantité du composé de silane contenu dans le film d'encapsulation de cellule solaire (14) est de 0,1 à 3,0 parties en poids pour 100 parties en poids du copolymère d'éthylène/α-oléfine.

6. Emballage (10) selon la revendication 2, dans lequel la résine modifiée au silane est un produit modifié pouvant être obtenu par greffage de 100 parties en poids du copolymère d'éthylène/α-oléfine avec 0,1 à 5 parties en poids d'un composé de silane polymérisable.

7. Emballage (10) selon la revendication 1, dans lequel une teneur d'atome de silicium (Si) dans le film d'encapsulation de cellule solaire (14) est de 300 à 4 000 ppm sur la base d'un poids du film d'encapsulation de cellule solaire (14).

8. Emballage (10) selon la revendication 1, dans lequel l'emballage (10) comprend un empilement de la pluralité de films d'encapsulation de cellule solaire (14).

9. Emballage (10) selon la revendication 1, dans lequel le sac d'emballage (12) contient une résine polyoléfinique.

10. Emballage (10) selon la revendication 1, dans lequel le sac d'emballage (12) présente une perméabilité à l'humidité de 1 g/(24 h·m²) ou moins.

11. Emballage (10) selon la revendication 1, comprenant en outre un conditionneur d'humidité à l'intérieur de l'emballage (10).

12. Emballage (10) selon la revendication 11, dans lequel le conditionneur d'humidité est au moins un élément choisi dans le groupe constitué de gel de silice, de chlorure de calcium et de chlorure de magnésium.

13. Procédé de stockage ou transport d'un film d'encapsulation de cellule solaire (14) contenant un composé de silane et/ou une résine modifiée au silane, le procédé comprenant :
l'emballage du film d'encapsulation de cellule solaire (14) avec un sac d'emballage (12) pour fournir un emballage (10) présentant une humidité absolue interne de 3 à 8 g/m³ ; et
le stockage ou transport du film d'encapsulation de cellule solaire (14) dans un environnement sombre pendant 50 heures ou plus.
